(19) Europäisches Patentamt

European Patent Office

Office européen des brevets

(11) **EP 1 454 416 B1**

(12) **EUROPEAN PATENT SPECIFICATION**

(45) Date of publication and mention
of the grant of the patent:
**14.06.2006 Bulletin 2006/24**

(51) Int Cl.:
*H03M 7/12* (2006.01)    *H03H 9/64* (2006.01)
*H03M 3/00* (2006.01)

(21) Application number: **02786344.8**

(22) Date of filing: **13.11.2002**

(86) International application number:
**PCT/SG2002/000266**

(87) International publication number:
**WO 2003/043198 (22.05.2003 Gazette 2003/21)**

(54) **BANDPASS SIGMA-DELTA MODULATOR WITH ANTI-RESONANCE CANCELLATION**

BANDPASS-SIGMA-DELTA-MODULATOR MIT ANTIRESONANZAUFHEBUNG

MODULATEUR SIGMA-DELTA PASSE-BANDE A ANNULATION D'ANTI-RESONANCE

(84) Designated Contracting States:
**AT BE BG CH CY CZ DE DK EE ES FI FR GB GR
IE IT LI LU MC NL PT SE SK TR**

(30) Priority: **13.11.2001 US 331256 P
03.07.2002 US 188071**

(43) Date of publication of application:
**08.09.2004 Bulletin 2004/37**

(60) Divisional application:
**06002858.6**

(73) Proprietor: **NATIONAL UNIVERSITY OF
SINGAPORE
Singapore 119260 (SG)**

(72) Inventors:
• **XU, Yong Ping**
  **Singapore 129793 (SG)**
• **SUN, Wai Hoong**
  **Singapore 560559 (SG)**
• **WANG, Xiaofeng**
  **Henan Province 476000 (CN)**
• **WANG, Zhe**
  **Singapore 120206 (SG)**
• **LIW, Sean Ian Saxon**
  **Singapore 400329 (SG)**

(74) Representative: **Klunker . Schmitt-Nilson . Hirsch
Winzererstrasse 106
80797 München (DE)**

(56) References cited:
**EP-A- 0 740 411        FR-A- 2 823 619
US-A- 4 577 168        US-A- 4 754 242
US-A- 5 283 578        US-B1- 6 292 121**

• **PATENT ABSTRACTS OF JAPAN vol. 2002, no.
02, 2 April 2002 (2002-04-02) & JP 2001 298365 A
(NIPPON TELEGR & TELEPH CORP), 26 October
2001 (2001-10-26)**
• **CHEN, WAI-KAI: "Two-Port Synthesis by Ladder
Development" 1995 , THE CIRCUITS AND
FITTERS HANDBOOK 72, CRC PRESS, INC. ,
CHICAGO XP002254884 ISBN 0-8493-8341-2
page 2276 -page 2291**

## Description

Technical Field

The present invention relates to a bandpass sigma-delta modulator, and more particularly to a bandpass sigma-delta modulator using an acoustic resonator or micro-mechanical resonator. The present invention also relates to a method of bandpass sigma-delta modulation of an input signal for cancelling the anti-resonance In micro-mechanical, surface acoustic wave (SAW) and bulk acoustic wave (BAW) resonators.

Background Art

Cellular telephone systems have become very popular in many countries throughout the wond. Unfortunately, the specific standards adopted by different countries are often different and cellular devices from one country will not be operable within another system. Accordingly, completely different handsets are necessary if a person is operating in two different countries having different standards.

As a result of this difficulty, there have been some efforts to provide a single device that is operable in different countries having different standards. A technology known as software-defined radio (SDR) provides one solution to this problem. In the SDR system, the entire band of RF or IF signal is digitized and the channel is selected using a programmable digital filter. Thus, the SDR can be reconfigured through the software to suit different standards. However, this effort has not been completely successful because it requires a high-speed A/D converter that must have not only high-speed, but also provide adequate resolution. In the ideal SDR arrangement, the RF is directly digitized in the receiver. It requires that the A/D converter have a speed in the gigahertz range, and also have a dynamic range over a 100 dB, which is equivalent to a 16-bit resolution. Among the various A/D converters, the sigma-delta A/D converter has promise in achieving the desired dynamic range. However, it is only achievable at a much lower frequency band. As the frequency increases, circuit imperfections become dominant and degrade the dynamic range of the A/D converter. At the gigahertz sampling frequency range, the highest dynamic range for the reported bandpass sigma-delta modulator is 75 dB, which only corresponds to a 12.5 bit resolution.

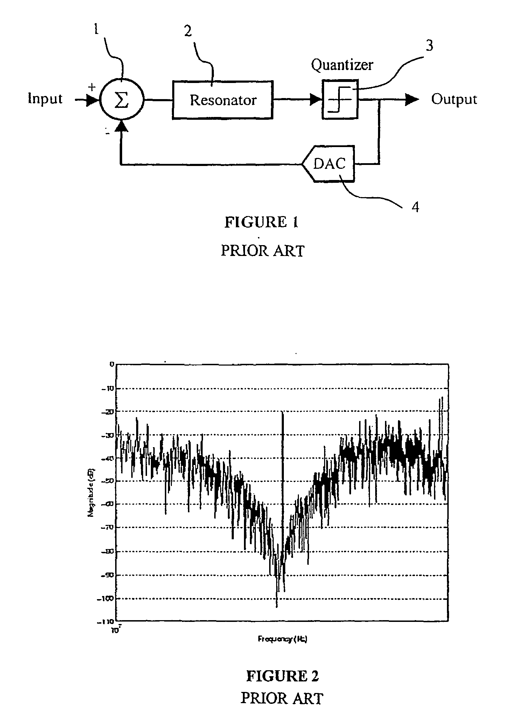

A sigma-delta A/D converter consists of a sigma-delta modulator and a digital filter. Figure 1 shows a typical arrangement of a bandpass sigma-delta modulator. The key element in the modulator is the resonator 2 which provides the quantization noise shaping. That is, the resonator acts as a bandpass filter in a band around its resonance frequency. The resonator needs to operate at a high frequency and have a high Q (quality factor) value. The output of the resonator is passed to a quantizer 3 which produces a digital "1" signal if its input exceeds a threshold and a digital "0" signal if the input is less than the threshold. This digital signal of a series of 0's and 1's becomes the output of the sigma-delta modulator. These signals are also fed back to a D/A converter 4, and the resultant analog signal is applied as a second input to summation device 1 which also receives the input to the modulator. The difference between the input and the feedback of the summation device produces an input to the resonator.

Figure 2 shows a typical output spectrum from a fourth order bandpass sigma-delta modulator where the quantization noise is shaped away from the resonance frequency, resulting in a very high dynamic range. The depth of the notch is related to the Q value of the resonator. The higher the Q value is, the deeper the notch. The noise shaping is also dependent on the order of the modulator. Higher order modulators provide better noise shaping and hence a higher dynamic range.

Typically, the resonator is made of one of three different electronic circuits, namely, a passive L-C tank, a transconductor-capacitor or a switch-capacitor. However, none of these circuits have been successful in the situation described. The first two circuits cannot achieve a high Q value due to parasitic losses and non-linearity. Typical Q values are around 10 and 40 for the integrated L-C tank with and without Q enhancement, respectively. The enhanced Q value for the transconductor-capacitor resonator can be up to 300 at a frequency of several hundred MHz. The switch-capacitor resonator is restricted by its low resonant frequency (< 100 MHz) due to the slow settling behavior of the circuit. The use of these types of resonators prevents the sigma-delta modulator from achieving a high speed and high dynamic range at the same time as is required in an SDR situation. In order to achieve a workable SDR system, it is necessary to find a resonator which is usable in a sigma-delta modulator to achieve high speed and high dynamic range.

In these resonators, there are two modes of resonance, namely the series mode and the parallel mode. In the series mode, the impedance of the resonator is at a minimum. In the parallel mode, the impedance of the resonator is at a maximum. The frequency at which the series resonance occurs Is referred to as the resonant frequency while the frequency at which the parallel resonance mode occurs is called the anti-resonant frequency.

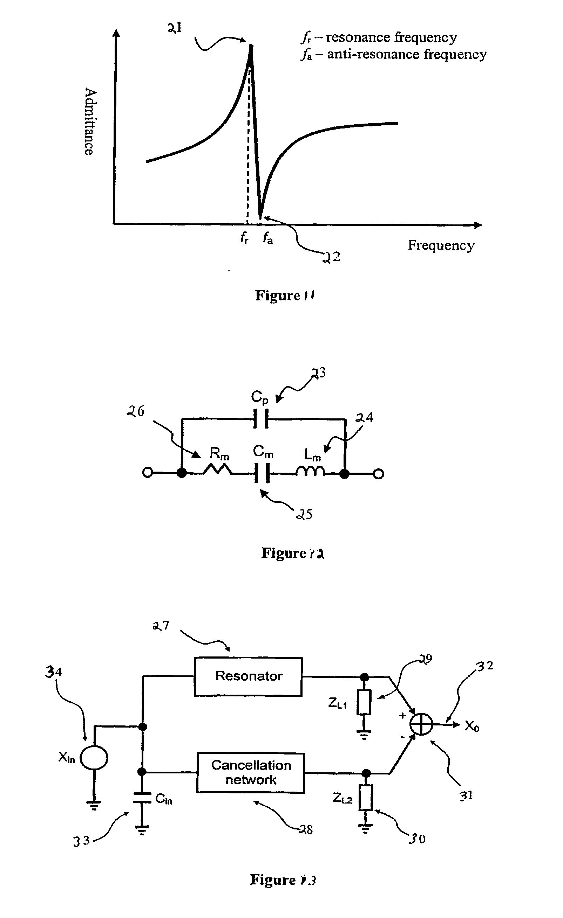

Figure 11 is a graph showing the relationship between the frequency of the resonator and the admittance (inverse of impedance). A maximum point is seen at 21 which is the series resonance mode. This occurs at frequency $f_r$. A minimum point 22 is the parallel resonance mode which occurs at the anti-resonance frequency $f_a$.

Figure 12 shows a typical equivalent circuit for a resonator. It includes a static capacitance $C_p$, 23 which is connected in parallel to a series circuit of resistor $R_m$, 26, capacitor $C_m$, 25 and inductor $L_m$, 24. The static capacitance 23 alters the transfer function of the ideal resonator by introducing two transmission zeros. In different applications, the presence of the anti-resonance may be desirable, such as in filtering and making oscillators. However, in other situations, it is not desirable such as in the sigma-delta modulator of Figure 1 discussed above. The presence of anti-resonance makes it difficult to realize the transfer function of the modulator and therefore it is desirable that it be cancelled. Likewise, in other modulators and in other situations, it may be desirable to cancel the anti-resonance in order that the resonance peak is emphasized. Patent Abstracts of Japan vol. 2002, no. 02. JP 2001 298 365 A relates to noise shaping A/D conversion circuit having a SAW filter as a resonator, and a single feedback using one D/A converter.

US-5,283,578 relates to a delta-sigma A/D converter of high frequency narrow band signals employing multi stage modulators cascaded with digital filters using respective single feedbacks.

## DISCLOSURE OF INVENTION

Accordingly, one object of this invention is to provide a bandpass sigma-delta modulator having high-speed and high-dynamic range, using a micro-mechanical resonator or an acoustic resonator. This object is achieved by the features of claim 1. Preferred embodiments are defined by the dependent claims.

The bandpass sigma-delta modulator has two D/A converters and may have two D/A converters and two summation devices.

An object of this invention is to provide a method of bandpass sigma-delta modulation of an input signal for canceling the anti-<HHY>canceling the anti-resonance in resonators. This is achieved by the feature of claim 11.

The invention provides a method and circuit for the cancellation of anti-resonance in micro-mechanical, SAW and BAW resonators.

Briefly, according to the invention, there are used either a micro-mechanical resonator or an acoustical resonator as a bandpass filter which provides an output to a quantizer. The output of the quantizer acts as the output of the modulator and is also fed back to two different D/A converters. The output of the two converters is adjusted by a gain and applied to a summation device, along with the input. The output of the summation device is applied as an input to the resonator. In the fourth order device, two resonators are used along with a second summation device. A cancellation network having a common input with a resonator and having an output which is subtracted from the output of the resonator is provided to cancel the anti-resonance.

## BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:

Figure 1 is a block diagram of a prior art bandpass sigma-delta modulator.
Figure 2 is a graph of the output spectrum from a typical fourth order modulator.
Figure 3 is a block diagram of a second order bandpass sigma-delta modulator using a micro-mechanical resonator according to the present invention.
Figure 4 is a graph of the output spectrum from the second order bandpass sigma-delta modulator of Figure 3.
Figure 5 block diagram of a fourth order bandpass sigma-delta modulator using micro-mechanical resonators.
Figure 6 is a graph of the output spectrum from a fourth order bandpass sigma-delta modulator according to Figure 5.
Figure 7 is a block diagram of the second order bandpass sigma-delta modulator using an acoustical resonator.
Figure 8 is a graph of the output spectrum from a second order bandpass sigma-delta modulator shown in Figure 7.
Figure 9 is a block diagram of a fourth order bandpass sigma-delta modulator using acoustical resonators.
Figure 10 is a graph showing the output spectrum from a fourth order bandpass sigma-delta modulator as shown in Figure 9.
Figure 11 is a graph illustrating the relationship between frequency and admittance of a resonator;
Figure 12 is an equivalent circuit for a prior art resonator;
Figure 13 is a circuit diagram of a first embodiment of the present invention;
Figure 14 is a detailed circuit diagram of the embodiment shown in Figure 13;
Figure 15 is a detailed circuit diagram of the second embodiment of the present invention;
Figure 16 is a graph of a frequency response for a resonator according to the prior art; and
Figure 17 is a graph of a frequency response for a resonator according to the present invention.

## BEST MODES FOR CARRYING OUT THE INVENTION

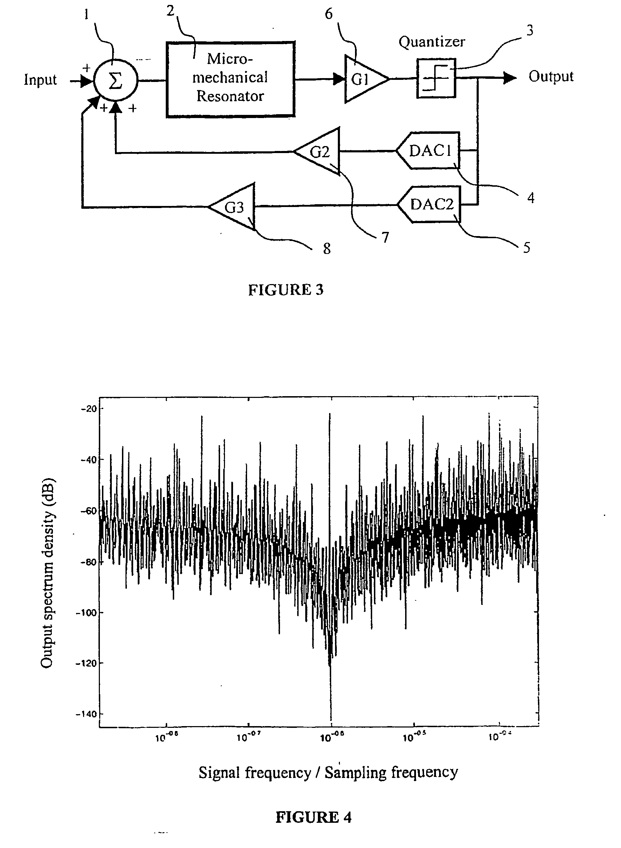

Referring now to the drawings, wherein like reference numerals designate identical corresponding parts throughout the several views, and more particularly to Figure 3 which shows a second order sigma-delta modulator using a micro-mechanical resonator. The summing circuit 1 adds the analog input to two outputs from two gain stages. The sum forming the output of the summing circuit becomes the input to the micro-mechanical resonator 2. The resonator selectively passes the signal at its resonance frequency and attenuates signals at other frequencies. The output from the resonator is adjusted by gain stage G1, 6 and fed to quantizer 3. The signal is quantized to form a series of binary bits as in Figure 1 which form the output of the modulator. The output is also fed back as an input to a pair of D/A converters, DAC1, 4, and DAC2, 5. The converters are both one bit converters but have different output pulses. One is a return to zero converter, whereas the other is a half return to zero converter. As a result, they have different transfer functions in the frequency domain. The output of the converters are analog signals which are fed back to the summing circuit through gain stages G2, 7 and G3, 8. The value of the gains in G1-G3 may be either positive or negative and often the gains in the feedback path are negative so that the feedback is subtracted from the input signal in a similar fashion to Figure 1.

Since the micro-mechanical resonator 2 is a second order system, the bandpass modulator shown in Figure 3 is of the second order, and provides second order noise-shaping as shown in Figure 4. This modulator based on the micro-mechanical resonator is capable of digitizing the analog input signal, but with a limited resolution. Better resolution can be obtained using a fourth order modulator as will be described below. However, since the Q values of the micro-mechanical resonator can easily be greater than 1000 and even as high as 10,000, it is possible to have a high resonance frequency, up to a gigahertz using this type of resonator. Accordingly, the use of this different resonator allows the modulator to operate at the gigahertz sampling frequency range with good resolution.

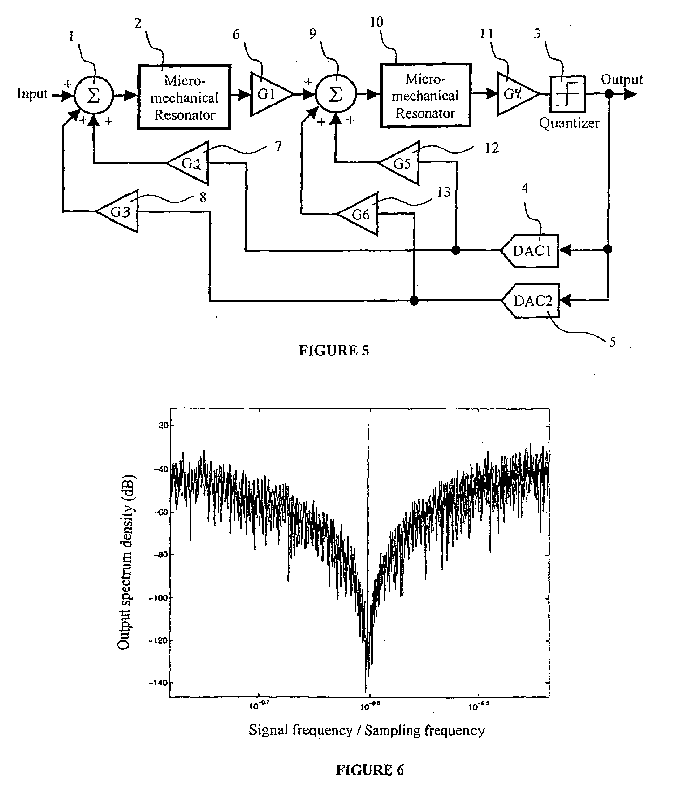

Figure 5 illustrates a corresponding fourth order bandpass sigma-delta modulator using a micro-mechanical resonator. Input summing circuit 1 adds the input to the modulator and the feedback from 2 gain stages in a similar fashion to Figure 3. The output of the summing circuit is fed to micro-mechanical resonator 2 which produces an output to gain stage G1, 6. This output is then applied to the second summing circuit 9 along with two additional feedback signals. The sum of these signals is used as the input to the second micro-mechanical resonator 10 which also selectively passes the signal at the resonance frequency and attenuates the signal at other frequencies. This output is adjusted by gain stage G4, 11 and its output is applied to quantizer 3. The output of the quantizer is a series of digital bits as described above and forms the output of the modulator. This output is fed back to two converters D/A converters 4 and 5 in a similar fashion to Figure 3. However, in addition to the analog feedback signal being applied to gain stages G2 and G3 as in Figure 3, they are also applied to gain stages G5, 12, and G6, 13 as inputs to the second summing circuit 9.

The output is the output of a fourth order bandpass sigma-delta modulator having a digitized form of the input analog signal. By having two micro-mechanical resonators in the loop, this device provides fourth order noise-shaping as shown in Figure 6. This fourth order modulator using two micro-mechanical resonators is able to provide digitization of the analog signal with high resolution.

As in the embodiment of Figure 3, the gain stages can be either positive or negative, and either gain or attenuation, as necessary.

Another type of resonator which has superior performance to electronic resonators are acoustic resonators. A surface acoustic wave (SAW) resonator has a resonance frequency of 50 - 2,000 MHz. It also has a Q factor of 4,000 - 15,000. A film bulk acoustic resonator (FBAR) has a resonance frequency of 300 - 10,000 MHz and a Q factor of 100 to 1000. The use of these types of resonators in the bandpass sigma-delta modulator also produces a digital output with high resolution at high frequencies.

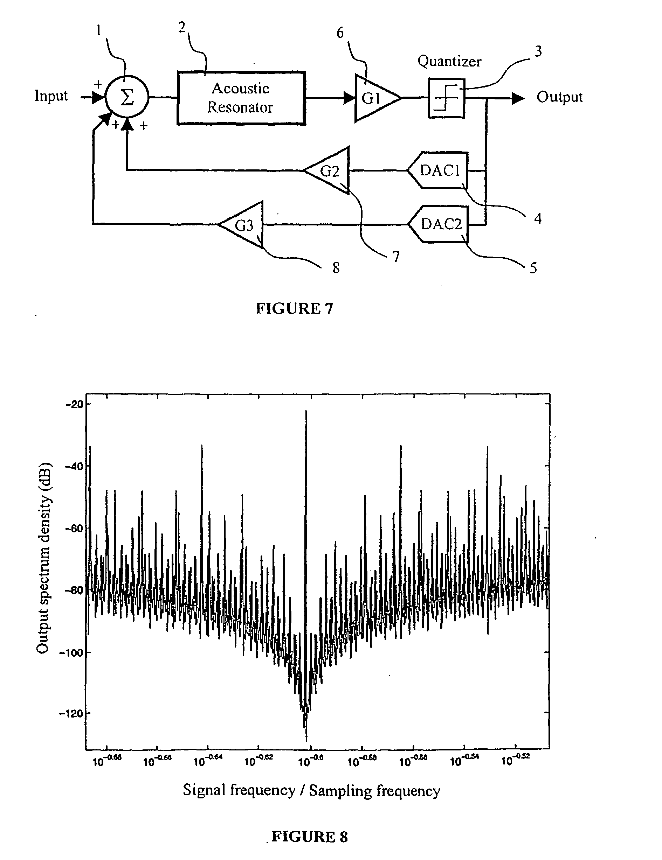

Figure 7 shows a bandpass sigma-delta modulator using an acoustic resonator 2. The remaining parts of the circuit operate in a similar fashion to that of Figure 3. Since the acoustic resonator 2 is a second order system, the bandpass sigma-delta modulator shown in Figure 7 is of second order and provides second order noise-shaping as shown in Figure 8. This modulator using an acoustic resonator is capable of digitizing the analog input signal, but with less resolution than a fourth order modulator.

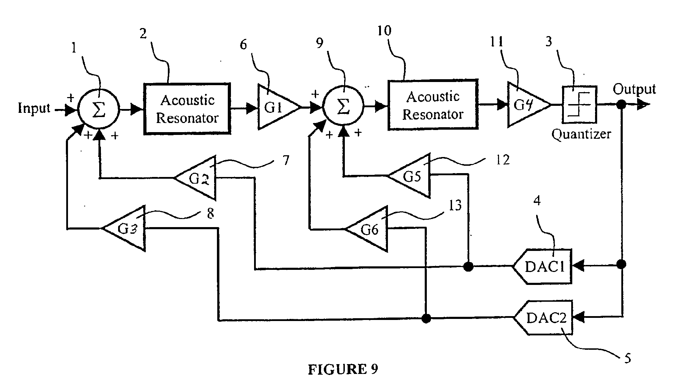

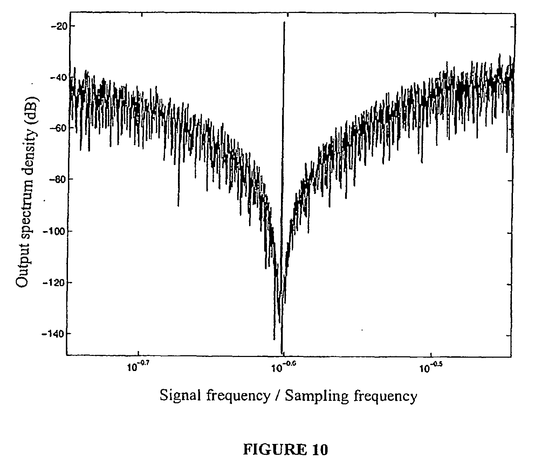

Figure 9 shows such a fourth order bandpass sigma-delta modulator using acoustic resonators. This arrangement is similar to that shown in Figure 5, but uses acoustic resonators rather than micro-mechanical resonators. Since there are two acoustic resonators in the loop, the modulator provides a fourth order noise shaping as shown in Figure 10 and is therefore of fourth order. This fourth order bandpass sigma-delta modulator using acoustic resonators is able to provide the digitization of the analog signal with a high resolution at high frequency.

Figure 13 shows the system with anti-resonance cancellation. An input signal from the signal generator $X_{in}$ 34, is applied to both resonator 27 and cancellation network 28. The output of the cancellation network is subtracted from the output of the resonator circuit in the subtractor 31. Lumped loads $Z_{l1}$, 29 and $Z_{l2}$, 30 are provided at the outputs of the resonator and cancellation network, respectively. These consist of the input impedances of the subtractor as well as parasitic impedances at the respective notes. Capacitor $C_{in}$ 33, is a lumped parasitic capacitance at the input node. The output of the subtractor $X_o$, 32, provides a signal with the anti-resonance being removed from the usual resonator output. This is accomplished as long as certain parameters of the cancellation network assume the proper values.

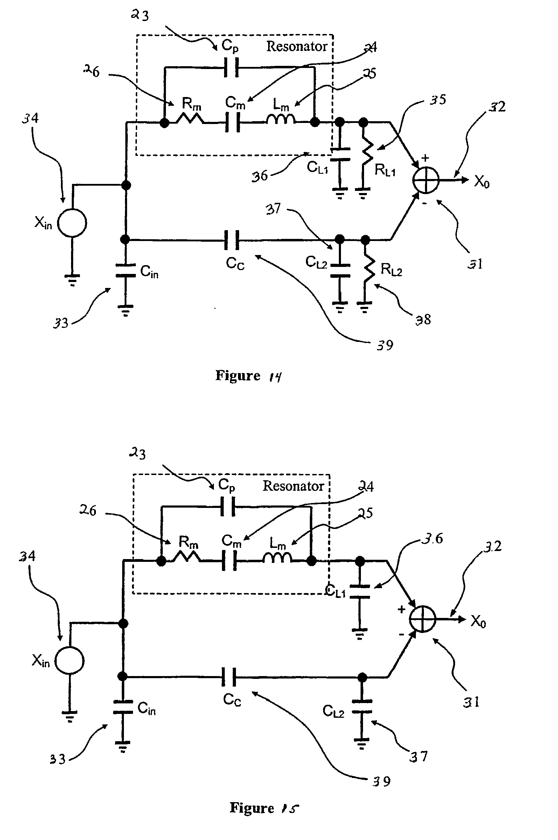

Figure 14 shows a more detailed cancellation circuit of the first embodiment. As shown, the lumped loads 29 and 30 are each replaced by a parallel circuit of a resistor and capacitor. Thus, load 29 is shown as including resistor $R_{L1}$, 35, and capacitor $C_{L1}$, 36. Likewise, load 30 includes resistor $R_{L2}$, 38, and capacitor $C_{L2}$, 37. In this arrangement, the cancellation network is merely a capacitor $C_c$, 39. The resonator 27 includes the equivalent circuit such as shown in Figure 12. In order for the anti-resonance to be cancelled, it is necessary for the following conditions to be met:

$$C_p = C_c, \; R_{L1} = R_{L2} \text{ and } C_{L1} = C_{L2}.$$

The presence of the parasitic capacitance 33 at the input node has no effect on the cancellation of the anti-resonance.

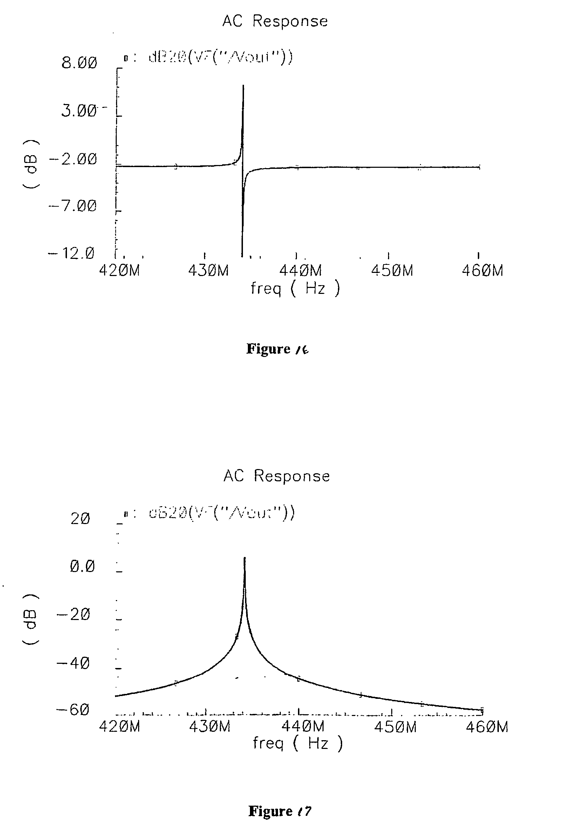

When these specific relationships are true, the output of the cancellation circuit is applied to the subtracting input of subtractor 31 to remove the anti-resonance part of the output curve from the resonator. Thus, by matching the parameters of the cancellation circuit to the parameters of various parts of the resonator part of the circuit, a signal is produced in the cancellation network which follows the anti-resonance signal. When this is subtracted from the output of the resonator, the anti-resonance part of the output is removed leaving the resonance part of the signal without having any anti-resonance. Thus, the output signal shown in Figure 16 which corresponds to the output of the resonator is then changed in the subtractor to produce an output such is shown in Figure 17 which does not include an anti-resonance.

Figure15 shows a second embodiment where the lumped loads 29 and 30 are purely capacitive and thus, are indicated by capacitors $C_{L1}$, 36, and $C_{L2}$, 37. In this case, the anti-resonance cancellation can be achieved by the following simple condition:

$$\frac{C_P}{C_{L1}} = \frac{C_C}{C_{L2}}$$

In this case, it is only necessary that the ratio of capacitors $C_P$ to $C_{L1}$ be equal to that of $C_C$ to $C_{L2}$. In this situation, the result is similar to that of the first embodiment shown in Figure 14 and described in Figures 16 and 17.

**Claims**

1. A bandpass sigma-delta modulator **characterised by** comprising:

   a first summing device (1) for receiving an input, a first feed back signal and a second feedback signal and producing an output;
   a first micro-mechanical or acoustic resonator (2) receiving the output of said first summing device (1) as an input and producing an output;
   a quantizer (3) receiving the output of said first micro-mechanical or acoustic resonator (2) and producing a digital output which is the output of said modulator; and
   a first D/A converter (4) and a second D/A converter (5), each receiving said output of said quantizer (3) as an input and respectively producing said first and second feedback signals, wherein said first and second D/A converters (4,5) have different transfer functions in the frequency domain.

2. The bandpass sigma-delta modulator according to claim 1, further comprising:

   a second summing device (9) receiving said output from said first micro-mechanical or acoustic resonator (2) and receiving third and fourth feedback signals and producing an output; and
   a second micro-mechanical or acoustic resonator (10) receiving said output from said second summing device (9) and producing an output which is received by said quantizer (3).

3. The bandpass sigma-delta modulator according to any one of claims 1, 2 or 3, wherein said first micro-mechanical or acoustic resonator (1) and second micro-mechanical or acoustic resonator (10) is a micro-mechanical resonator.

4. The bandpass sigma-delta modulator according to any one of claims 1, 2 3 or 4, wherein said first micro-mechanical or acoustic resonator (1) and second micro-mechanical or acoustic resonator (10) is an acoustic resonator.

5. The bandpass sigma-delta modulator according to claim 4, wherein said acoustic resonator is a surface acoustic wave resonator.

6. The bandpass sigma-delta modulator according to claim 4, wherein the acoustic resonator is a film bulk acoustic resonator.

7. The bandpass sigma-delta modulator according to any one of the preceding claims, wherein said first D/A converter (4) is a full return to zero converter and the second D/A converter (5) is a half return to zero converter.

8. The bandpass sigma-delta modulator according to any one of the preceding claims, wherein said first and second D/A converters (4,5) are one bit converters.

9. The bandpass sigma-delta modulator according any one of the preceding claims, further comprising gain stages (7,8,6) provided between said first D/A converter (4) and said first summing device (1), between said second D/A converter (5) and said first summing device (1), and between said first micro-mechanical or acoustic resonator (2) and said quantizer (3).

10. The bandpass sigma-delta modulator according to claim 9, further comprising gain stages (11, 12, 13) between said second micro-mechanical or acoustic resonator (10) and said quantizer (3), between said first D/A converter (4) and said second summing device (9), and between said second D/A converter (5) and said second summing device (9).

11. A method of bandpass sigma-delta modulation of an input signal **characterised by** comprising the steps of:

summing a first feed back signal, a second feedback signal and the input signal to produce an output;

passing the output from the summing step through a first micro-mechanical or acoustic resonator (2) and producing an output;

passing the output from the first micro-mechanical or acoustic resonator (2) through a quantizer (3) and producing a digital output; and

passing the output from said quantizer (3) through a first D/A converter (4) and a second D/A converter (5) and respectively producing said first and second feedback signals,

wherein said first and second D/A converters (4,5) have different transfer functions in the frequency domain.

**Patentansprüche**

1. Ein Bandpass-Sigma-Delta-Modulator, **dadurch gekennzeichnet, dass** er umfasst:

eine erste Summiereinrichtung (1) zum Empfangen einer Eingabe, eines ersten Rückkopplungssignals und eines zweiten Rückkopplungssignals und zum Erzeugen einer Ausgabe;

einen ersten mikromechanischen oder akustischen Resonator (2), der die Ausgabe der ersten Summiereinrichtung (1) als eine Eingabe empfängt und der eine Ausgabe erzeugt;

einen Quantisierer (3), der die Ausgabe des ersten mikromechanischen oder akustischen Resonators (2) empfängt und eine digitale Ausgabe erzeugt, welche die Ausgabe des Modulators ist; und

einen ersten D/A-Konverter (4) und einen zweiten D/A-Konverter (5), wobei jeder die Ausgabe des Quantisierers (3) als eine Eingabe empfängt und das erste beziehungsweise das zweite Rückkopplungssignal erzeugt,

wobei der erste und der zweite D/A-Konverter (4, 5) unterschiedliche Übertragungsfunktionen im Frequenzbereich besitzen.

2. Der Bandpass-Sigma-Delta-Modulator nach Anspruch 1, des Weiteren umfassend:

eine zweite Summiereinrichtung (9), welche die Ausgabe von dem ersten mikromechanischen oder akustischen Resonator (2) empfängt, dritte und vierte Rückkopplungssignale empfängt und eine Ausgabe erzeugt; und

einen zweiten mikromechanischen oder akustischen Resonator (10), der die Ausgabe von der zweiten Summiereinrichtung (9) empfängt und eine Ausgabe erzeugt, welche vom Quantisierer (3) empfangen wird.

3. Der Bandpass-Sigma-Delta-Modulator nach Anspruch 1 oder 2, wobei der erste mikromechanische oder akustische Resonator (1) und der zweite mikromechanische oder akustische Resonator (10) mikromechanische Resonatoren sind.

4. Der Bandpass-Sigma-Delta-Modulator nach Anspruch 1 oder 2, wobei der erste mikromechanische oder akustische Resonator (1) und der zweite mikromechanische oder akustische Resonator (10) akustische Resonatoren sind.

5. Der Bandpass-Sigma-Delta-Modulator nach Anspruch 4, wobei der akustische Resonator ein akustischer Oberflächenwellenresonator ist.

6. Der Bandpass-Sigma-Delta-Modulator nach Anspruch 4, wobei der akustische Resonator ein akustischer Volumendünnfilmresonator ist.

7. Der Bandpass-Sigma-Delta-Modulator nach einem der vorhergehenden Ansprüche, wobei der erste D/A-Konverter (4) ein Konverter mit vollständiger Rückkehr nach Null ist und der zweite D/A-Konverter (5) ein Konverter mit halber Rückkehr nach Null ist.

8. Der Bandpass-Sigma-Delta-Modulator nach einem der vorhergehenden Ansprüche, wobei der erste und der zweite D/A-Konverter (4, 5) Ein-Bit-Konverter sind.

9. Der Bandpass-Sigma-Delta-Modulator nach einem der vorhergehenden Ansprüche, des Weiteren umfassend Verstärkungsstufen (7, 8, 6), die zwischen dem ersten D/A-Konverter (4) und der ersten Summiereinrichtung (1), zwischen dem zweiten D/A-Konverter (5) und der ersten Summiereinrichtung (1) und zwischen dem ersten mikromechanischen oder akustischen Resonator (2) und dem Quantisierer (3) vorgesehen sind.

**10.** Der Bandpass-Sigma-Delta-Modulator nach Anspruch 9, des Weiteren umfassend Verstärkungsstufen (11, 12, 13) zwischen dem zweiten mikromechanischen oder akustischen Resonator (10) und dem Quantisierer (3), zwischen dem ersten D/A-Konverter (4) und der zweiten Summiereinrichtung (9) und zwischen dem zweiten D/A-Konverter (5) und der zweiten Summiereinrichtung (9).

**11.** Ein Verfahren einer Bandpass-Sigma-Delta-Modulation eines Eingabesignals, **dadurch gekennzeichnet, dass** es die Schritte umfasst:

Summieren eines ersten Rückkopplungssignals, eines zweiten Rückkopplungssignals und des Eingabesignals, um eine Ausgabe zu erzeugen;
Weitergeben der Ausgabe vom Summierschritt durch einen ersten mikromechanischen oder akustischen Resonator (2) und Erzeugen einer Ausgabe;
Weitergeben der Ausgabe vom ersten mikromechanischen oder akustischen Resonator (2) durch einen Quantisierer (3) und Erzeugen einer digitalen Ausgabe; und
Weitergeben der Ausgabe vom Quantisierer (3) durch einen ersten D/A-Konverter (4) und einen zweiten D/A-Konverter (5) und Erzeugen des ersten beziehungsweise zweiten Rückkopplungssignals,
wobei der erste und der zweite D/A-Konverter (4, 5) unterschiedliche Übertragungsfunktionen im Frequenzbereich besitzen.

**Revendications**

**1.** Modulateur sigma-delta passe-bande **caractérisé en ce qu'**il comprend :

un premier dispositif de sommation (1) pour recevoir une entrée, un premier signal de retour et un second signal de retour et pour produire une sortie ;
un premier résonateur micromécanique ou acoustique (2) qui reçoit la sortie dudit premier dispositif de sommation (1) en tant qu'entrée et qui produit une sortie ;
un quantificateur (3) qui reçoit la sortie dudit premier résonateur micromécanique ou acoustique (2) et qui produit une sortie numérique qui est la sortie dudit modulateur ; et
un premier convertisseur N/A (4) et un second convertisseur N/A (5) dont chacun reçoit ladite sortie dudit quantificateur (3) en tant qu'entrée et produit de façon respective lesdits premier et second signaux de retour,
dans lequel lesdits premier et second convertisseurs N/A (4, 5) présentent des fonctions de transfert différentes dans le domaine des fréquences.

**2.** Modulateur sigma-delta passe-bande selon la revendication 1, comprenant en outre :

un second dispositif de sommation (9) qui reçoit ladite sortie en provenance dudit premier résonateur micromécanique ou acoustique (2) et qui reçoit des troisième et quatrième signaux de retour et qui produit une sortie ; et
un second résonateur micromécanique ou acoustique (10) qui reçoit ladite sortie en provenance dudit second dispositif de sommation (9) et qui produit une sortie qui est reçue par ledit quantificateur (3).

**3.** Modulateur sigma-delta passe-bande selon l'une quelconque des revendications 1 ou 2, dans lequel ledit premier résonateur micromécanique ou acoustique (1) et ledit second résonateur micromécanique ou acoustique (10) sont un résonateur micromécanique.

**4.** Modulateur sigma-delta passe-bande selon l'une quelconque des revendications 1, 2 ou 3, dans lequel ledit premier résonateur micromécanique ou acoustique (1) et ledit second résonateur micromécanique ou acoustique (10) sont un résonateur acoustique.

**5.** Modulateur sigma-delta passe-bande selon la revendication 4, dans lequel ledit résonateur acoustique est un résonateur à ondes acoustiques de surface.

**6.** Modulateur sigma-delta passe-bande selon la revendication 4, dans lequel le résonateur acoustique est un résonateur acoustique dans la masse en film.

**7.** Modulateur sigma-delta passe-bande selon l'une quelconque des revendications précédentes, dans lequel ledit premier convertisseur N/A (4) est un convertisseur à retour complet à zéro et le second convertisseur N/A (5) est un convertisseur à demi-retour à zéro.

**8.** Modulateur sigma-delta passe-bande selon l'une quelconque des revendications précédentes, dans lequel lesdits premier et second convertisseurs N/A (4, 5) sont des convertisseurs à un bit.

**9.** Modulateur sigma-delta passe-bande selon l'une quelconque des revendications précédentes, comprenant en outre des étages de gain (7, 8, 6) qui sont prévus entre ledit premier convertisseur N/A (4) et ledit premier dispositif de sommation (1), entre ledit second convertisseur N/A (5) et ledit premier dispositif de sommation (1) et entre ledit premier résonateur micromécanique ou acoustique (2) et ledit quantificateur (3).

**10.** Modulateur sigma-delta passe-bande selon la revendication 9, comprenant en outre des étages de gain (11, 12, 13) entre ledit second résonateur micromécanique ou acoustique (10) et ledit quantificateur (3), entre ledit premier convertisseur N/A (4) et ledit second dispositif de sommation (9) et entre ledit second convertisseur N/A (5) et ledit second dispositif de sommation (9).

**11.** Procédé de modulation sigma-delta passe-bande d'un signal d'entrée, **caractérisé en ce qu'**il comprend, les étapes de :

sommation d'un premier signal de retour, d'un second signal de retour et du signal d'entrée pour produire une sortie ;
passage de la sortie en provenance de l'étape de sommation au travers d'un premier résonateur micromécanique ou acoustique (2) et production d'une sortie ;
passage de la sortie en provenance du premier résonateur micromécanique ou acoustique (2) au travers d'un quantificateur (3) et production d'une sortie numérique ; et
passage de la sortie en provenance dudit quantificateur (3) au travers d'un premier convertisseur N/A (4) et d'un second convertisseur N/A (5) et production de façon respective desdits premier et second signaux de retour,
dans lequel lesdits premier et second convertisseurs N/A (4, 5) présentent des fonctions de transfert différentes dans le domaine des fréquences.

FIGURE 1

PRIOR ART

FIGURE 2

PRIOR ART

FIGURE 3

Signal frequency / Sampling frequency

FIGURE 4

FIGURE 5

Signal frequency / Sampling frequency

FIGURE 6

**FIGURE 7**

Signal frequency / Sampling frequency

**FIGURE 8**

FIGURE 9

Signal frequency / Sampling frequency

**FIGURE 10**

21

$f_r$ – resonance frequency
$f_a$ – anti-resonance frequency

Admittance

$f_r$  $f_a$

Frequency

22

**Figure 11**

23

$C_p$

26

24

$R_m$  $C_m$  $L_m$

25

**Figure 12**

27

34

Resonator

29

32

$Z_{L1}$

$+$

$X_o$

$X_{In}$

$-$

31

Cancellation
network

$Z_{L2}$

$C_{In}$

28

30

33

**Figure 13**

15

Figure 14

Figure 15

AC Response

□ : dB20(VF("/Vout"))

Figure 16

AC Response

□ : dB20(VF("/Vout"))

Figure 17